# EUROPÄISCHE PATENTANMELDUNG

(11) **EP 0 961 122 A1**
(43) Veröffentlichungstag der Anmeldung: **01.12.1999**
(21) Anmeldenummer: 98109711.6
(22) Anmeldetag: 28.05.1998
(51) Int. Cl.: G01R 21/00, G01R 22/00, G01R 21/133

(54) **Elektrizitätszähler mit einem einen Mikrocomputer aufweisenden Basis-Elektrizitätszähler, der mit einem oder mehreren austauschbaren Zählerbausteinen bestückt ist**

(71) Anmelder: Electrowatt Technology Innovation AG, 6301 Zug (CH)
(72) Erfinder: Bammert, Kurt, 6102 Malters (CH); Loder Christian, 6048 Horw (CH); Gemsch, Leopold, 6423 Seewen (CH)

(57) **Zusammenfassung**

Die Zählerbausteine (1, 2) besitzen wahlweise jeweils eine oder mehrere Ausführungs-Varianten, die sich in ihrer Funktionalität unterscheiden, und weisen jeweils mindestens ein, den betreffenden Zählerbaustein (1, 2) und/oder die Ausführungs-Variante kennzeichnendes Identifikations-Merkmal auf. Das letztere ist vom Mikrocomputer (5) des Basis-Elektrizitätszählers (3) lesbar, sei es zwecks dortiger Verarbeitung und Interpretation seines Informationsinhaltes, sei es zwecks Überlassung des Identifikations-Merkmals an einer Applikations-Software des Elektrizitätszählers zur Interpretation des Informationsinhaltes. Die Erfindung hat den Vorteil, dass jede Bestückung bzw.
Bestückungsänderung des Elektrizitätszählers automatisch erkannt wird, wenn der Elektrititätszähler mit austauschbaren Zählerbausteinen und/oder Ausführungs-Varianten bestückt ist und die Bestückung im Laufe der Zeit veränderbar ist.

## Beschreibung

Die Erfindung bezieht sich auf einen Elektrizitätszähler mit einem einen Mikrocomputer aufweisenden Basis-Elektrizitätszähler, der mit einem oder mehreren austauschbaren Zählerbausteinen bestückt ist, gemäss dem Oberbegriff des Anspruchs 1.

Ein- und mehrphasige Elektrizitätszähler werden bekanntlich zum Messen elektrischer Energie verwendet, wie z. B. Wirk-, Blind- oder Scheinenergie. Der Elektrizitätszähler kann auch ein sogenannter Kombinationszähler sein, der gleichzeitig mehrere der erwähnten Energiearten misst. Die Elektrizitätszähler sind oft mit einem Tarifgerät ausgerüstet. Die Zählerbausteine sind vorzugsweise Kommunikations-Bausteine, sogenannte I/O-Module ("input/output-moduls") oder Tarifgeräte. Die letzteren können jedoch auch ein Teil des Basis-Elektrizitätszählers sein.

Aus der US-PS 5 694 607 ist ein tragbares Computer-System bekannt, das mit einem entfernbaren steckbaren Massenspeicher-Subsystem und einem entfernbaren steckbaren Radiofrequenz-Modem-Subsystem ausgerüstet ist, welches letzteres einer Telefax- und/oder Daten-Übertragung dient. Eine Software des Computer-Systems beinhaltet "plug and play"-Funktionen, um die Installation von Eingangs/Ausgangs-Bauelementen und Subsystemen in normierten Schlitzen des Computer-Systems zu erleichtern. Das letztere wird von einer Batterie mit Hilfe eines Speisegerätes gespeist, wobei verschiedene elektrische Leistungen des letzteren gemessen werden zur Bestimmung der verbleibenden Lebensdauer der Batterie. In einer Tabelle sind für vorhandene Hardware-Bestückungen und Software-Konfigurationen zugehörige maximale, minimale und mittlere Leistungsverbrauchs-Werte des Computer-Systems gespeichert, mit deren Hilfe unter anderem eine Änderung der Hardware-Konfiguration detektiert und die Tabelle entsprechend aufdatiert wird.

Der Erfindung liegt die Aufgabe zugrunde, einen Elektrizitätszähler der eingangs genannten Art so zu verwirklichen, dass jede Bestückung beziehungsweise Bestückungsänderung des Elektrizitätszählers automatisch erkannt wird, wenn der Elektrititätszähler je nach Ausführung mit unterschiedlichen und austauschbaren Zählerbausteinen und/oder Ausführungs-Varianten derselben bestückt ist und die Bestückung im Laufe der Zeit veränderbar ist.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

Ausführungsbeispiele der Erfindung sind in der Zeichnung dargestellt und werden im folgenden näher beschrieben.

Es zeigen:
- Fig. 1: einen Elektrizitätszähler mit einer geschlossenen Abdeckung,
- Fig. 2: einen Elektrizitätszähler mit einer geöffneten Abdeckung,
- Fig. 3: ein Blockschaltbild mit einer Übersicht von im erfindungsgemässen Elektrizitätszähler vorhandenen internen Bus-Schnittstellen und einer ersten Ausführungs-Variante eines Kommunikations-Zählerbausteins,
- Fig. 4: ein Blockschaltbild einer zweiten Ausführungs-Variante des Kommunikations-Zählerbausteins,
- Fig. 5: ein Blockschaltbild einer dritten Ausführungs-Variante des Kommunikations-Zählerbausteins,
- Fig. 6: ein Blockschaltbild einer vierten Ausführungs-Variante des Kommunikations-Zählerbausteins,
- Fig. 7: ein Blockschaltbild einer fünften Ausführungs-Variante des Kommunikations-Zählerbausteins,
- Fig. 8: ein Blockschaltbild einer ersten Variante einer Schnittstellen-Anordnung einer RS232-Schnittstelle,
- Fig. 9: ein Blockschaltbild einer zweiten Variante einer Schnittstellen-Anordnung einer RS232-Schnittstelle,
- Fig. 10: ein Blockschaltbild einer dritten Variante einer Schnittstellen-Anordnung einer RS232-Schnittstelle,
- Fig. 11: ein Blockschaltbild einer vierten Variante einer Schnittstellen-Anordnung einer RS232-Schnittstelle,
- Fig. 12: ein Blockschaltbild einer ersten Variante einer Schnittstellen-Anordnung einer RS485-Schnittstelle,
- Fig. 13: ein Blockschaltbild einer zweiten Variante einer Schnittstellen-Anordnung einer RS485-Schnittstelle,
- Fig. 14: ein Blockschaltbild einer dritten Variante einer Schnittstellen-Anordnung einer RS485-Schnittstelle,
- Fig. 15: ein Blockschaltbild einer ersten Variante einer Schnittstellen-Anordnung einer M-Bus-Schnittstelle,
- Fig. 16: ein Blockschaltbild einer zweiten Variante einer Schnittstellen-Anordnung einer M-Bus-Schnittstelle,
- Fig. 17: ein Blockschaltbild einer dritten Variante einer Schnittstellen-Anordnung einer M-Bus-Schnittstelle,
- Fig. 18: ein Blockschaltbild einer vierten Variante einer Schnittstellen-Anordnung einer M-Bus-Schnittstelle,
- Fig. 19: ein Blockschaltbild einer ersten Variante einer Schnittstellen-Anordnung einer Telefon-Schnittstelle,
- Fig. 20: ein Blockschaltbild einer zweiten Variante einer Schnittstellen-Anordnung einer Telefon-Schnittstelle,
- Fig. 21: ein Blockschaltbild einer dritten Variante einer Schnittstellen-Anordnung einer Telefon-Schnittstelle und
- Fig. 22: ein Blockschaltbild einer vierten Variante einer Schnittstellen-Anordnung einer Telefon-Schnittstelle.

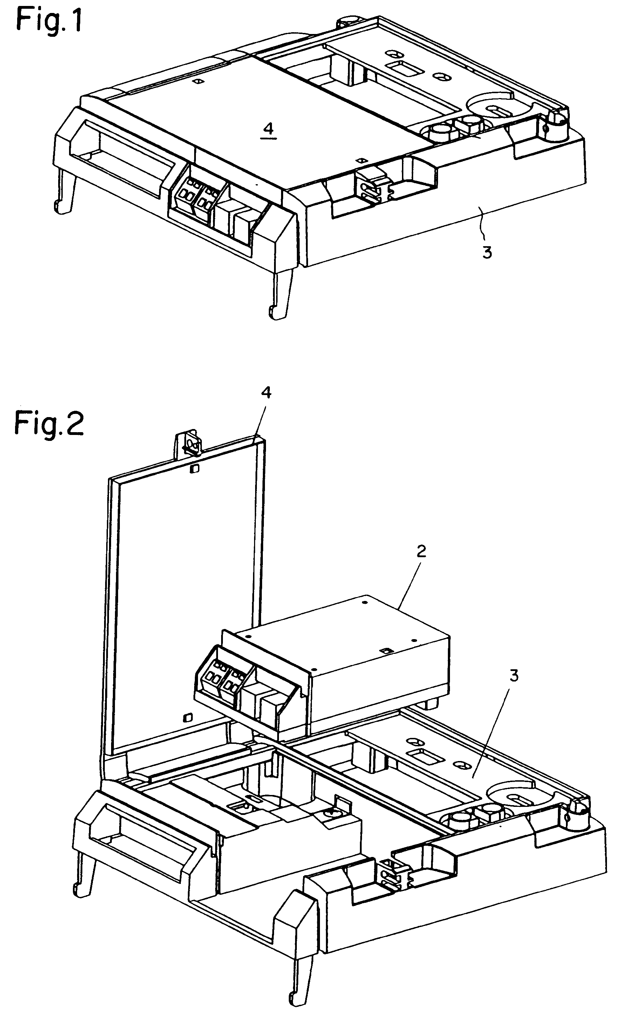

Ein erfindungsgemässer Elektrizitätszähler ist mit einem Basis-Elektrizitätszähler 3 versehen, der fakultativ mit einem oder mehreren Zählerbausteinen bestückt ist. Die Zählerbausteine sind vorzugsweise steckbare Module (siehe Fig. 2) oder steckbare Leiterplatten. Nachfolgend gilt die Annahme, dass ein erster Zählerbaustein 1 und ein zweiter Zählerbaustein 2 im Elektrizitätszähler vorhanden sind. Der Zählerbaustein 1 ist z. B. ein als I/O-Modul bezeichneter Eingangs/Ausgangs-Zählerbaustein, während der Zählerbaustein 2 z. B. ein Kommunikations-Baustein ist. Die Zählerbausteine besitzen wahlweise jeweils eine oder mehrere Ausführungs-Varianten, die sich in ihrer Funktionalität unterscheiden und nachfolgend auch als Optionen bezeichnet werden. Der Zählerbaustein 2 z. B. besitzt verschiedene Varianten von vorzugsweise normierten und an sich bekannten Kommunikations-Schnittstellen, wie z. B. RS232-, RS485-, CS-, M-Bus- und/oder Modem-Schnittstellen. Die Kommunikations-Optionen sind im Feld nachrüstbar, daher ist der Zählerbaustein 2 in der Regel unter einer mit einer Werkplombe versehenen Abdeckung 4 angeordnet. In der Fig. 1 ist ein Elektrizitätszähler mit einer geschlossenen Abdeckung 4 und in der Fig. 2 ein solcher mit einer geöffneten Abdeckung 4 dargestellt. In der Fig. 2 ist ein steckbarer, als Modul ausgebildeter Zählerbaustein 2 aus dem Basis-Elektrizitätszähler 3 herausgezogen dargestellt. Das I/O-Modul, also der Zählerbaustein 1, ist dagegen in der Regel in demjenigen Teils des Elektrizitätszählers angeordnet, der mit einer Eichplombe geschützt ist.

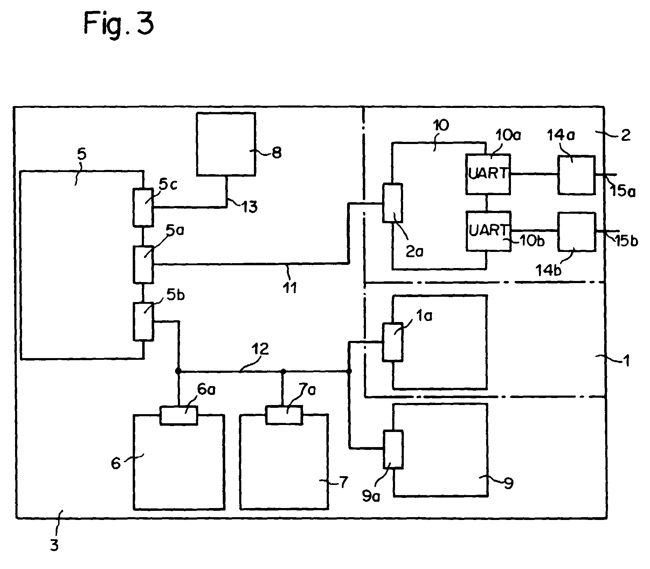

Der Basis-Elektrizitätszähler 3 (siehe Fig. 3) weist einen Mikrocomputer 5, einen Basis-Speicher 6, einen Options-Speicher 7, eine optische Schnittstelle 8 sowie einen Elektronik-Chip 9 auf. Im Options-Speicher 7 sind unter anderem alle für eine Kommunikation benötigten Roh-Daten gespeichert. Die Bauelemente 5 bis 9 sind z. B. auf zwei Leiterplatten angeordnet, nämlich eine Basis-Leiterplatte mit Standardfunktionen und eine Bedienungsplatte mit Zubehör-Elementen zu einer Bedienung. Die Zählerbausteine 1 und 2 sind z. B. auf der Basis-Leiterplatte des Basis-Elektrizitätszählers 3 steckbar. Wenn alle Daten- und Steuerleitungen eines externen Modems getrennt von der Basis-Leiterplatte auf die Zählerbausteine 1 und/oder 2 geführt wären, würde dies einerseits sehr viele Verbindungen erfordern und anderseits müssten alle Kommunikations-Protokolle bereits im voraus, anlässlich einer ersten Inbetriebsetzung des Elektrizitätszählers bekannt und im Basis-Elektrizitätszähler 3 implementiert sein, was eine unflexible und teure Lösung ergeben würde. Um eine möglichst preisgünstige Lösung zu erhalten, ist die Schnittstelle zwischen dem Basis-Elektrizitätszähler 3 und den Zählerbausteinen 1 und 2 mit möglichst wenig Leitungen verwirklicht. Die Verbindung zwischen der Basis-Leiterplatte des Basis-Elektrizitätszählers 3, den Zählerbausteinen 1 und 2 sowie dem Elektronik-Chip 9 ist dementsprechend vorzugsweise mittels serieller, wahlweise sychroner oder asynchroner Schnittstellen realisiert, was eine sehr flexible Lösung auch für zukünftige Änderungen der Ausführungs-Varianten der Zählerbausteine 1 und/oder 2 ergibt. Dies bedingt jedoch, dass der Kommunikations-Baustein, also der Zählerbaustein 2, einen eigenen Mikrocomputer enthält, welcher nachfolgend als Kommunikations-Mikrocomputer 10 bezeichnet wird. Der Zählerbaustein 2 enthält somit die OSI-Schichten des Kommunikation-Stacks und weist verschiedene "physical layers" auf. Durch die Implementierung des Kommunikations-Stacks in den Kommunikations-Mikrocomputer 10 erfolgen, ausgehend von den Roh-Daten der Kommunikation, die im Options-Speicher 7 des Basis-Elektrizitätszählers 3 gespeichert sind, alle Datenformat-Umwandlungen, die für eine Kommunikation erforderlich sind, im Kommunikations-Mikrocomputer 10. Durch den letzteren wird der Mikrocomputer 5 des Basis-Elektrizitätszählers 3 von einem Teil seiner Arbeit entlastet, da untere Schichten des Elektrizitätszählers-Stacks auf den Kommunikations-Mikrocomputer 10 des Zählerbausteins 2 ausgelagert sind. Die Implementierung des Kommunikations-Stacks auf den externen Kommunikations-Mikrocomputer 10 besitzt nicht nur den Vorteil, dass der Mikrocomputer 5 des Basis-Elektrizitätszählers teilweise entlastet wird, sondern auch den Vorteil, dass einerseits die Software und Mikrocomputer-Maske des Basis-Elektrizitätszählers 3 nicht geändert werden muss bei einer Änderung und/oder Erweiterung der Kommunikations-Option und anderseits der Basis-Elektrizitätszähler 3 kostengünstig ausgeführt werden kann, sowie der Aufbau des Elektrizitätszähler auch für die Zukunft eine sehr flexible Lösung darstellt. Wie aus der Fig. 3 ersichtlich, ist eine serielle Schnittstelle 5a des Mikrocomputers 5 des Basis-Elektrizitätszählers 3 über eine normierte bidirektionale Busverbindung 11 mit einer seriellen Schnittstelle 2a des Zählerbausteins 2 verbunden zwecks serieller bidirektionaler Übertragungen von Informationen zwischen diesen Bauelementen. Eine weitere serielle Schnittstelle 5b des Mikrocomputers 5 ist innerhalb des Basis-Elektrizitätszählers 3 über eine weitere normierte bidirektionale Busverbindung 12 mit einer seriellen Schnittstelle 1a des Zählerbausteins 1, 6a des Basis-Speichers 6, 7a des Options-Speichers 7 und 9a des Elektronik-Chips 9 verbunden. Eine UART-Schnittstelle 5c des Mikrocomputers 5 ist über UART-Verbindungen 13 mit der optischen Schnittstelle 8 verbunden. Der Kommunikations-Mikrocomputer 10 ist jeweils über eine externe zugehörige Schnittstellen-Anordnung 14a bzw. 14b mit einem oder mehreren, vorzugsweise mit zwei Übertragungskanälen 15a und 15b verbunden. Nachfolgend und in der Zeichnung gilt die Annahme, dass pro Zählerbaustein 2 zwei Übertragungskanäle 15a und 15b mit je eine Kommunikations-Schnittstelle vorhanden sind. In einer ersten, in der Fig. 3 dargestellten Ausführungs-Variante des Zählerbausteins 2 gilt die Annahme, dass der Kommunikations-Mikrocomputer 10 zwei interne UART-Schnittstellen 10a und 10b besitzt, die jeweils über eine zugehörige Schnittstellen-Anordnung 14a bzw. 14b mit einem der zwei Übertragungskanäle 15a bzw. 15b verbunden sind.

Die Erfindung ermöglicht ein Nachrüsten bereits installierter Elektrizitätszähler mit anderen Zählerbausteinen 1 und/oder 2 bzw. mit anderen Ausführungs-Varianten bereits vorhandener Zählerbausteine 1 und/oder 2. Eine anfänglich vorhandene Bestückung des Basis-Elektrizitätszählers 3 mit Zählerbausteinen und/oder Ausführungs-Varianten ist somit nachträglich änderbar. Für jeden montierten Zählerbaustein 1 und/oder 2 muss im Basis-Elektrizitätszähler 3 eine zugehörige Parametrierung vorhanden sein, welche deren Funktionalität unterstützt. Der Elektrizitätszähler oder dessen auch als Parametrier-Software verwendete Applikations-Software erkennt erfindungsgemäss den jeweiligen, auf dem Basis-Elektrizitätszähler 3 gesteckten Zählerbaustein 1 und/oder 2 sowie die Gültigkeit einer zugehörigen Parametrierung. Zu diesem Zweck weist der Zählerbaustein 1 bzw. 2 mindestens ein Identifikations-Merkmal auf, welches den betreffenden Zählerbaustein 1 bzw. 2 und/oder eine Ausführungs-Variante desselben kennzeichnet. Das Identifikations-Merkmal ist vom Mikrocomputer 5 des Basis-Elektrizitätszählers 3 lesbar zwecks dortiger Verarbeitung und Interpretation seines Informationsinhaltes durch den Mikrocomputer 5 oder zwecks Überlassung des Identifikations-Merkmals an einer Applikations-Software des Elektrizitätszählers zur Interpretation des Informationsinhaltes. Das Identifikations-Merkmal ist vorzugsweise codiert. In einer erfindungsgemässen ersten Variante ist eine Software des Mikrocomputers 5 bzw. die Applikations-Software des Elektrizitätszählers so ausgebildet, dass sie bei der Interpretation des Informationsinhaltes des Identifikations-Merkmals erkennt, ob zum betreffenden Zählerbaustein 1 oder 2 bzw. zur betreffenden Ausführungs-Variante eine entsprechende Parametrierung bereits im Basis-Elektrizitätszähler 3 vorhanden ist. Ansonsten erfolgt durch den Basis-Elektrizitätszähler 3 eine Warnung und/oder eine Aufforderung zur Umparametrierung und/oder eine softwaremässige Betriebssperrung des betreffenden Zählerbausteins 1 bzw. 2. Das Identifikations-Merkmal ist in dieser ersten Variante in einem vorzugsweise nichtflüchtigen Speicher des betreffenden Zählerbausteins gespeichert oder es ist ein, von einem Codierer des betreffenden Zählerbausteins erzeugtes Identifikations-Merkmal. Im letzteren Fall besteht der Codierer vorzugsweise aus einer Reihe von "Pull up"- oder "Pull down"-Widerständen und/oder ist das Identifikations-Merkmal mittels Codierschalter implementiert. Dabei ist das Identifikations-Merkmal seriell - über die Busverbindung 11 - oder parallel vom Mikrocomputer 5 lesbar. Das Identifikations-Merkmal ist entweder eine fortlaufende, für jede Option unterschiedliche Nummer eines Zählerbausteins bzw. einer Ausführungs-Variante oder es ist ein Kennmerkmal, welches eine Aussage bezüglich der Funktionalität des Zählerbausteins bzw. der Ausführungs-Variante enthält. Zum Erkennen eines gültigen Zählerbausteins bzw. einer gültigen Ausführungs-Variante wird bei einer Parametrierung des Elektrizitätszählers je eine Kopie der gültigen Identifikations-Merkmale des Zählerbausteins 1 und/oder 2 im Options-Speicher 7 des Basis-Elektrizitätszählers 3 abgelegt. Bei jedem Neustart oder periodisch kontrolliert eine Zähler-Software die Übereinstimmung des gerade gelesenen Identifikations-Merkmals der vorhandenen Zählerbausteine 1 und/oder 2 mit den abgelegten Kopien der gültigen Identifikations-Merkmale. Stimmt dabei das gelesene Identifikations-Merkmal mit einer der abgelegten Kopien überein, wird die parametrierte Funktionalität initialisiert. Kann dagegen keine einzige Identifikation festgestellt werden, so werden die Verbindungen zum betreffenden Zählerbaustein 1 bzw. 2 getrennt, d. h. hochohmig gemacht. Stimmt die gelesene codierte Identifikation mit keiner der abgelegten Kopien überein, wird ausserdem dem Anwender eine Warnung und/oder eine Aufforderung zur Umparametrierung gegeben und/oder es erfolgt eine softwaremässige Betriebssperrung des betreffenden Zählerbausteins 1 bzw. 2. Wird also ein falscher Zählerbaustein 1 bzw. 2 oder eine falsche Ausführungs-Variante auf den Basis-Elektrizitätszähler 3 gesteckt, so wird z. B. die Hardware des Zählerbausteins 1 bzw. 2 sowie diejenige des Basis-Elektrizitätszählers 3 durch die Trennung geschützt und die Nichtübereinstimmung angezeigt. Die Anzeige und Warnung erfolgt z. B. durch ein Blinken einer Flüssigkristallanzeige (LCD), welche normalerweise Messdaten des Elektrizitätszählers anzeigt. Ein nachträgliches Bestücken des Basis-Elektrizitätszählers 3 mit einem anderen Zählerbaustein oder einer anderen Ausführungs-Variante ist somit jederzeits möglich, unter der Bedingung, dass eine Kopie des zugehörigen Identifikations-Merkmals zum Parametrierzeitpunkt mit zugehöriger Parametrierung im Basis-Elektrizitätszähler 3 abgelegt wurde. Wenn nicht, erfolgt eine Warnung und/oder Aufforderung zu einer Umparametrierung. Dabei interpretiert die Parametrier-Software des Elektrizitätszählers - ohne Aufdatieren der Parametrier-Software - die neu vorhandene Option, bevor einzelne Elemente des Zählerbausteins 1 bzw. 2 in die Zähler-Funktionalität einbezogen werden.

Die bisher beschriebene Verwendung des Identifikations-Merkmals dient rein zur Erkennung der auf dem Zählerbaustein 1 bzw. 2 vorhandenen Hardware. Bei einem späteren Wechsel eines Zählerbausteins 1 und/oder 2 muss aber oft eine durch die Warnung ausgelöste Umparametrierung erfolgen. Um dies zu vermeiden, ist in einer zweiten erfindungsgemässen Variante das Identifikations-Merkmal vorzugsweise eine zum betreffenden Zählerbaustein bzw. zur betreffenden Ausführungs-Variante gehörende Parametrierung, die in einem Speicher des Zählerbausteins 1 bzw. 2 gespeichert ist und - vom Mikrocomputer 5 gelesen - zur Parametrierung des Basis-Elektrizitätszählers 3 dient. Diese in den Zählerbausteinen 1 und/oder 2 gespeicherte Parametrierung kann vom Mikrocomputer 5 jeweils automatisch abgerufen und im Options-Speicher 7 des Basis-Elektrizitätszählers 3 gespeichert werden, so dass bei einem Wechsel einer Option die betreffende Parametrierung automatisch erfolgt und keine Umparametrierung von aussen erforderlich ist. In diesem Fall arbeitet der Elektrizitätszähler nach dem sogenannten "plug and play"-Prinzip. Dank des letzteren kann einerseits eine zum Zählerbaustein 1 bzw. 2 gehörende Ausführungs-Variante unabhängig vom Typ des Elektrizitätszählers auf eine künftige Funktionalität und andererseits das Verhalten des Elektrizitätszählers - unabhängig von der Art oder Präsenz einer Option - auf den Umgang mit weiteren Optionen vorbereitet werden.

Zur Erkennung einer nachträglichen Bestückungsänderung ist eine Software des Mikrocomputers 5 so ausgebildet, dass der letztere periodisch und/oder bei allen Inbetriebsetzungen des Elektrizitätszählers automatisch die Identifikations-Merkmale der vorhandenen Zählerbausteine 1 und/oder 2 liest und auswertet. Durch die Erfindung wird so verhindert, dass ein Zählerbaustein 1 bzw. 2 im Elektrizitätszähler installiert wird, obwohl in ihm keine zugehörige oder eine falsche Parametrierung vorhanden ist. Das Identifikations-Merkmal gestattet es jeweils dem Mikrocomputer 5 oder der Applikations-Software des Elektrizitätszählers automatisch festzustellen, ob eine im Zählerbaustein 1 und/oder 2 vorhandene Hardware eine gültige Option ist und ob in der Zwischenzeit eine Bestückungsänderung im Elektrizitätszähler stattgefunden hat.

Wie bereits erwähnt, gibt es für die beiden Zählerbausteine 1 und 2 eine Vielzahl von Ausführungs-Varianten. Alle diese Optionen müssen Daten-Schnittstellen aufweisen, die gegenüber der Aussenwelt eine Isolationsspannungs-Festigkeit von 4kV Wechselspannung während einer Minute besitzen. Zur Realisierung dieser hohen Anforderung ist eine galvanische Trennung der Signale erforderlich, wobei die Trennung auf verschiedene Weise erfolgen kann. Dabei gibt es unter anderem auch Lösungen mit integrierten Schaltungen, die im Handel erhältlich sind. Vorzugsweise wird eine neutrale Schnittstelle zwischen dem Basis-Elektrizitätszähler 3 und dem Zählerbaustein 2 verwendet mit einer Entkopplung der Kommunikation und der Zähler-Applikation, wobei eine allgemeingültige Zähler-Applikation und spezifische Anforderungen eines Kommunikations-Protokolls aufeinander angepasst sind. Für den Zählerbaustein 2 gibt es vorzugsweise die fünf nachfolgend beschriebenen Ausführungs-Varianten.

In der ersten Ausführungs-Variante (siehe Fig. 3) sind, wie bereits erwähnt, zwei interne UART-Schnittstellen 10a und 10b des Kommunikations-Mikrocomputers 10 über je eine zugehörige Schnittstellen-Anordnung 14a bzw. 14b mit je einem Übertragungskanal 15a bzw. 15b verbunden.

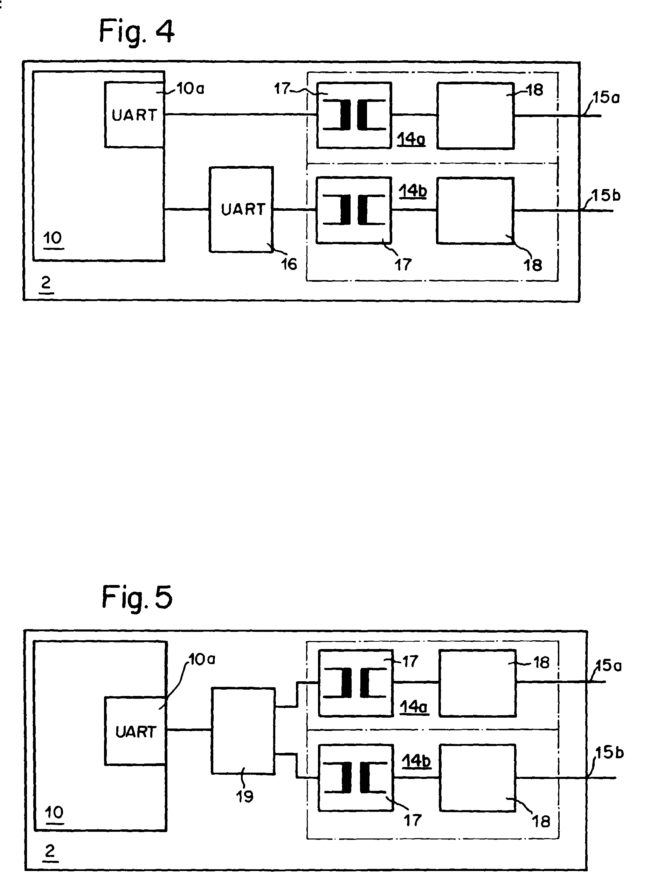

In einer zweiten Ausführungs-Variante (siehe Fig. 4) ist einerseits eine interne UART-Schnittstelle 10a des Kommunikations-Mikrocomputers 10 über eine erste Schnittstellen-Anordnung 14a mit einem zugehörigen ersten Übertragungskanal 15a verbunden und anderseits der Kommunikations-Mikrocomputer 10 in der angegebenen Reihenfolge über eine externe UART-Schnittstelle 16 und eine zweite Schnittstellen-Anordnung 14b mit einem zugehörigen zweiten Übertragungskanal 15b verbunden. Der Kommunikations-Mikrocomputer 10 ist z. B. vom Typ NEC 7805X der Firma NEC und die externe UART-Schnittstelle 16 z. B. vom Typ NS16C450 der Firma National Semiconductor.

In einer dritten Ausführungs-Variante (siehe Fig. 5) ist eine interne UART-Schnittstelle 10a des Kommunikations-Mikrocomputers 10 über einen gemeinsamen externen Signal-Multiplexer 19 mit zwei Schnittstellen-Anordnungen 14a und 14b verbunden, die jeweils auf einen zugehörigen Übertragungskanal 15a bzw. 15b geführt sind. Der Kommunikations-Mikrocomputer 10 ist z. B. vom Typ NEC 7805X der Firma NEC und der externe Signal-Multiplexer z. B. vom Typ MAX4519 der Firma Maxim. Die Kommunikationspartner müssen in dieser kostengünstigen dritten Ausführungs-Variante fehlertolerant sein.

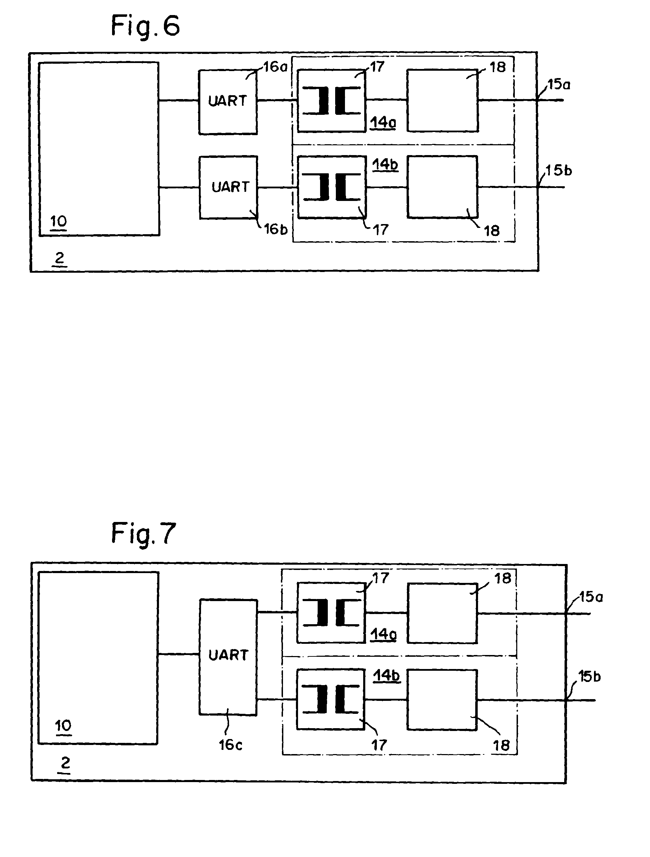

In einer vierten Ausführungs-Variante (siehe Fig. 6) ist der Kommunikations-Mikrocomputer 10 in der angegebenen Reihenfolge jeweils über eine externe UART-Schnittstelle 16a bzw. 16b und die Schnittstellen-Anordnung 14a bzw. 14b mit je einem zugehörigen von zwei Übertragungskanälen 15a bzw. 15b verbunden. Der Kommunikations-Mikrocomputer 10 kann ein kleinerer Mikrocomputer sein, z. B. einer vom Typ NEC 7801X der Firma NEC, und die externen, relativ teueren UART-Schnittstellen 16a und 16b sind z. B. vom Typ NS16C450 der Firma National Semiconductor. Die durch die Verwendung externer UART-Schnittstellen 16a und 16b bedingte Verteuerung wird nur zum Teil kompensiert durch Verwendung des kleineren, billigeren Mikrocomputers 10a. Ausserdem ist ein grösserer Platzbedarf erforderlich.

In einer fünften Ausführungs-Variante (siehe Fig. 7) ist der Kommunikations-Mikrocomputer 10 über eine Dualausführung einer externen UART-Schnittstelle 16c mit den beiden Schnittstellen-Anordnungen 14a und 14b verbunden, die jeweils auf einen zugehörigen Übertragungskanal 15a bzw. 15b geführt sind. Der Kommunikations-Mikrocomputer 10 ist ein kleinerer Mikrocomputer z. B. vom Typ NEC 7801X der Firma NEC und die externe UART-Schnittstellen 16c in Dualausführung z. B. vom Typ MCCS16C462 der Firma Motorola. Ein Nachteil dieser Ausführungs-Variante ist, dass eine UART-Schnittstelle zuviel ist und im Leerlauf mitläuft, wenn der Zählerbaustein 2 nur mit einer einzigen Schnittstelle bestückt sein muss. Die fünfte Ausführungs-Variante ist daher nicht kostenoptimal.

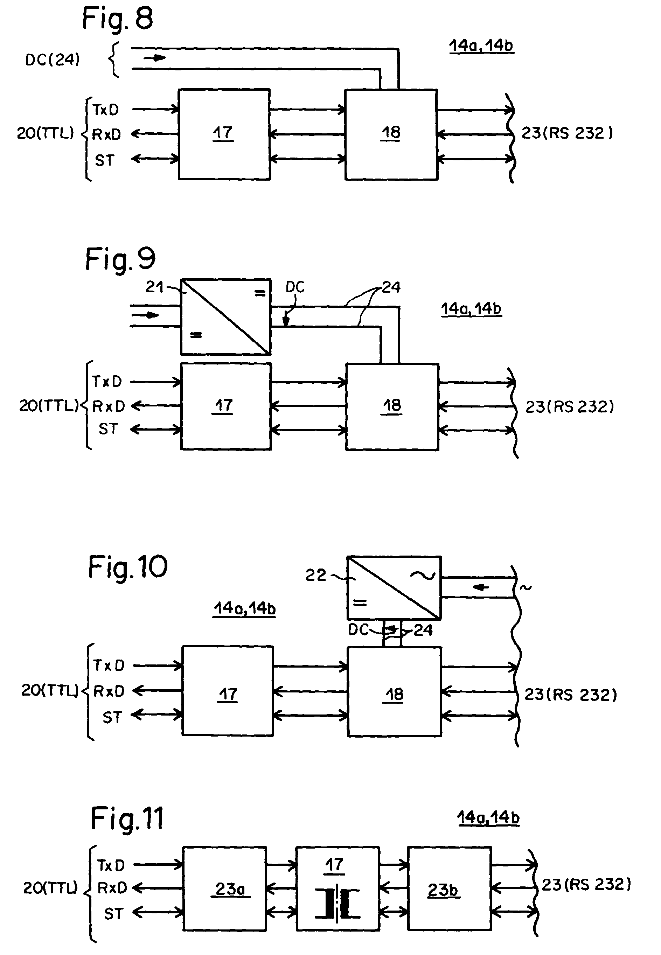

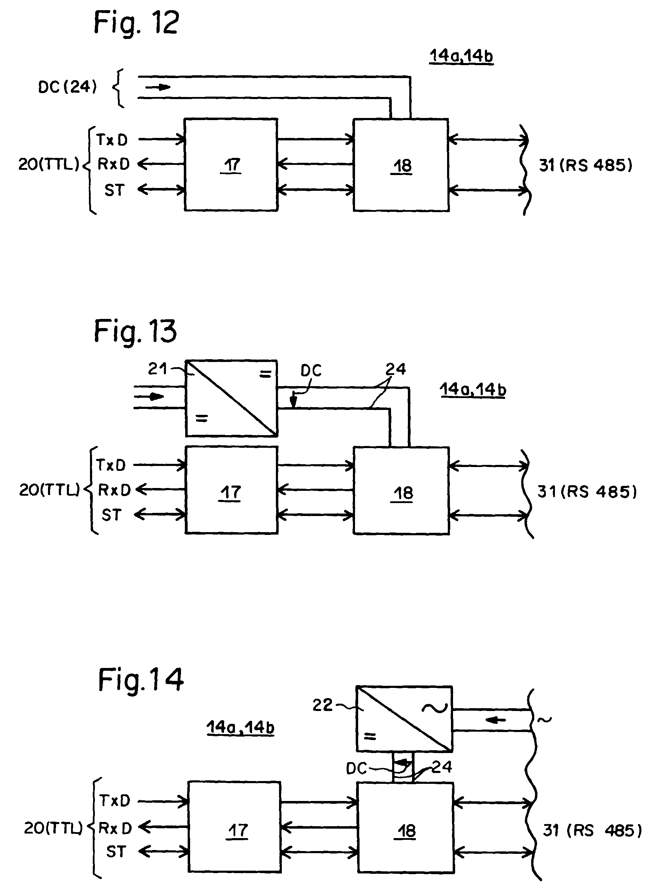

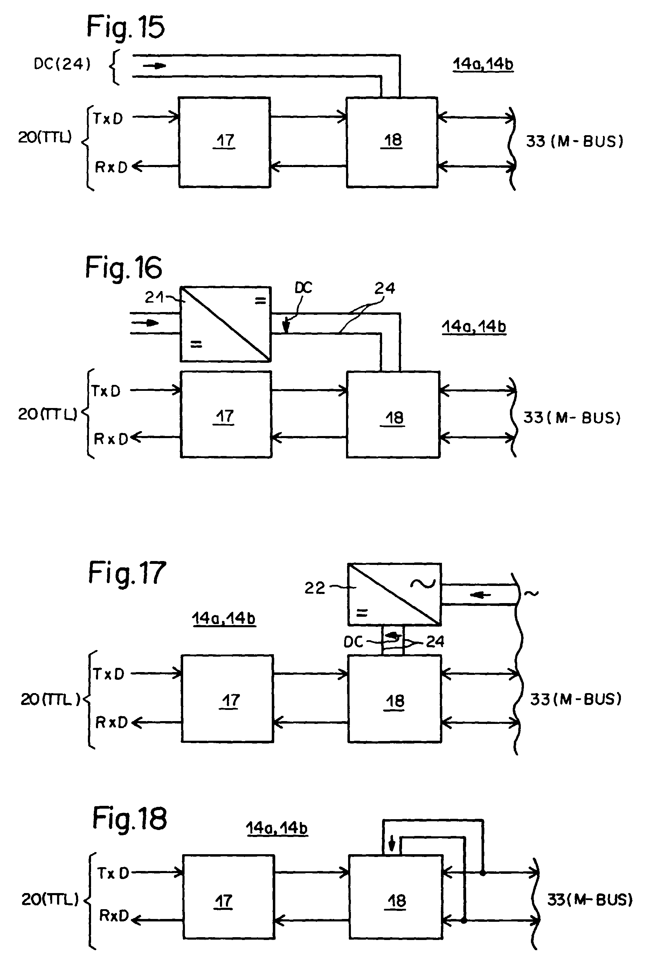

Die Schnittstellen-Anordnungen 14a und 14b beinhalten jeweils eine normierte RS232-, RS485-, M-Bus- oder Telefon-Schnittstelle. In den drei ersten Fällen, mit Ausnahme der in der Fig. 11 dargestellten RS232-Schnittstelle, enthalten die Schnittstellen-Anordnungen 14a und 14b jeweils eine Reihenschaltung einer galvanischen Trennschaltung 17 und einer Pegelanpass-Schaltung 18 (siehe Fig. 8 bis Fig. 10 und Fig.12 bis Fig. 18). Die galvanische Trennschaltung 17 ist mit Optokopplern oder Spannungswandlern aufgebaut. In der Fig. 4 bis Fig. 7 wurde das Vorhandensein von Spannungswandlern angenommen. Die Pegelanpass-Schaltung 18 ist jeweils so ausgebildet, dass sie eine normierte RS232-Schnittstelle (Fig. 8 bis Fig. 10) bzw. RS485-Schnittstelle (Fig. 12 bis Fig. 14) bzw. M-Bus-Schnittstelle (Fig. 15 bis Fig. 18) bildet. Sie ist vorzugsweise mittels Verstärker aufgebaut und bevorzugt ein handelsübliches Bauelement z. B. vom Typ MAX232, MAX250, LTC485 oder TSS721.

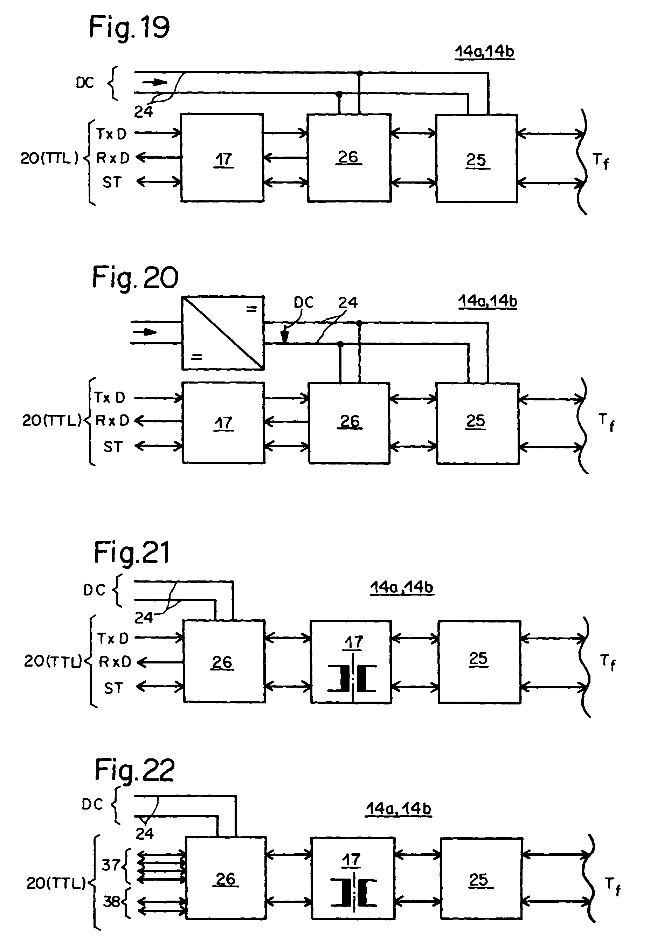

Die UART-Schnittstellen 10a, 10b, 16, 16a, 16b und 16c besitzen auf Seite der Schnittstellen-Anordnungen 14a und 14b Anschlüsse mit TTL-Pegeln ("transistor transistor logic"), die in der Regel zum Anschliessen einer Empfangsleitung RxD ("receive"), einer Sendeleitung TxD ("transmit") und mindestes einer bidirektionalen Steuerleitung ST dienen. Diese Leitungen - mit oder ohne Steuerleitung ST - werden nachfolgend kurz als TTL-Leitungen 20 bezeichnet (siehe Fig. 8 bis Fig. 21). In der in der Fig. 22 dargestellten Schnittstellen-Anordnung 14a bzw. 14b bestehen die TTL-Leitungen 20 ausnahmsweise aus zwei parallelen Busverbindungen 37 und 38. In allen Varianten der Schnittstellen-Anordnungen 14a und 14b sind die TTL-Leitungen 20 im Kommunikations-Baustein in der Regel an Anschlüsse der galvanischen Trennschaltung 17 angeschlossen (siehe Fig. 8 bis Fig. 10 und Fig. 12 bis Fig. 20). Ausgenommen sind die in der Fig. 11 dargestellte Variante, wo die TTL-Leitungen20 an ein erstes ASK-Modem 23a angeschlossen sind, und die in der Fig. 21 sowie Fig. 22 dargestellten Varianten, wo die TTL-Leitungen 20 an ein Modem-IC 26 angeschlossen sind.

In den in der Fig. 8, Fig. 12 und Fig. 15 dargestellten Varianten der Schnittstellen-Anordnung 14a bzw. 14b ist die Pegelanpass-Schaltung 18 von einer im Basis-Elektrizitätszähler 3 enthaltenen Elektrizitätszähler-Hauptspeisung gespeist, die so ausgebildet ist, dass eine galvanische Trennung einer von der Pegelanpass-Schaltung 18 benötigten Speise-Gleichspannung DC durch einen Transformator der Hauptspeisung erfolgt. Die letztere speist in diesen Varianten einen Speiseeingang der Pegelanpass-Schaltung 18 über zwei Leitungen 24. Die Elektrizitätszähler-Hauptspeisung ist in der Zeichnung nicht dargestellt.

In den in der Fig. 9, Fig. 13 und Fig. 16 dargestellten Varianten der Schnittstellen-Anordnung 14a bzw. 14b ist die Pegelanpass-Schaltung 18 von einem im Kommunikations-Baustein enthaltenen Gleichstrom/Gleichstrom-Wandler 21 gespeist, der so ausgebildet ist, dass eine galvanische Trennung der von der Pegelanpass-Schaltung 18 benötigten Speise-Gleichspannung DC innerhalb des Gleichstrom/Gleichstrom-Wandlers 21 erfolgt. Ein Ausgang des letzteren speist über die Leitungen 24 einen Speiseeingang der Pegelanpass-Schaltung 18, während ein Eingang des Gleichstrom/Gleichstrom-Wandlers 21 von der im Basis-Elektrizitätszähler 3 enthaltenen Elektrizitätszähler-Hauptspeisung gespeist ist. In diesen Varianten erfolgt die gesamte galvanische Trennung im Zählerbaustein 2. Der Gleichspannung/Gleichspannung-Wandler 21 ist vorzugsweise ein handelsübliches Bauelement z. B. vom Typ MAX635 oder MAX251 der Firma Maxim.

In den in der Fig. 10, Fig. 14 und Fig. 17 dargestellten Varianten der Schnittstellen-Anordnung 14a bzw. 14b ist die Pegelanpass-Schaltung 18 von einem im Kommunikations-Baustein enthaltenen Netzgerät 22 gespeist welches so ausgebildet ist, dass eine galvanische Trennung der von der Pegelanpass-Schaltung 18 benötigten Speise-Gleichspannung DC innerhalb des Netzgerätes 22 erfolgt. Der Eingang des letzteren wird von der Seite des Übertragungskanals 15a bzw. 15b mit einer Wechselspannung gespeist. Der Zählerbaustein 2 benötigt somit ein eigenes Netzgerät 22, was einen relativ grossen Aufwand darstellt und dementsprechend teuer ist.

In der in der Fig. 18 dargestellten Variante der Schnittstellen-Anordnung 14a bzw. 14b ist die Pegelanpass-Schaltung 18 so ausgebildet dass sie eine normierte M-Bus-Schnittstelle bildet, wobei übertragungskanalseitige Anschlüsse der Pegelanpass-Schaltung 18 mit Speisespannungs-Anschlüssen der Pegelanpass-Schaltung 18 verbunden sind, so dass die Pegelanpass-Schaltung 18 ab dem M-Bus, d. h. ab dem Übertragungskanal 15a bzw. 15b gespeist ist. Dies ist möglich, da die Spezifikation des M-Buses vorsieht dass ein Sklave, z. B. die Pegelanpass-Schaltung 18, eine kleine Speiseleistung über den M-Bus beziehen darf. Diese Variante ist eine kostenoptimale Lösung, da keine galvanische Trennung der Speisespannung erforderlich ist.

In der in der Fig. 11 dargestellten Variante der Schnittstellen-Anordnung 14a bzw. 14b enthält die Schnittstellen-Anordnung 14a bzw. 14b jeweils in der angegebenen Reihenfolge eine Reihenschaltung eines ersten ASK-Modems 23a ("amplitude shift keying modem": Amplitudentast-Modulator/Demodulator), einer galvanischen Trennschaltungen 17 und eines zweiten ASK-Modems 23b. Dabei ist das letztere so ausgebildet dass es eine RS232-Schnittstelle bildet. Es besitzt zu diesem Zweck aufder Seite des Übertragungskanals 15a bzw. 15b eine Pegelanpassung. Die Gleichspannungs-Signale aufden TTL-Leitungen 20 werden im ersten ASK-Modem 23a in modulierte Wechselstrom-Signale umgewandelt welche mittels der Trennschaltung 17 galvanisch getrennt werden, um im zweiten ASK-Modem 23b wieder in Gleichspannungs-Signale umgewandelt zu werden, die diesmal allerdings RS232-Pegeln aufweisen. Diese Variante stellt eine aufwendige Lösung dar, weil die gesamte Logik konventionell aufgebaut sein muss, da zur Zeit keine handelübliche Bauelemente existieren.

In den in der Fig. 19 bis Fig. 22 dargestellten Varianten beinhalten die Schnittstellen-Anordnungen 14a und 14b jeweils eine Telefon-Schnittstelle. In den in der Fig. 19 und Fig. 20 dargestellten Varianten enthält die Schnittstellen-Anordnung 14a bzw. 14b jeweils eine Reihenschaltung in der angegebenen Reihenfolge einer galvanischen Trennschaltung 17, eines mit Steuerfunktionen versehenen Modem-IC's 26 und einer Telefon-Ankopplungsschaltung 25. Die letztere ist dabei so ausgebildet, dass sie eine Telefon-Schnittstelle bildet. Die Telefon-Ankopplungsschaltung 25 ist auf Seite des Übertragungskanals an der Telefonleitung Tf angeschlossen. In der in der Fig. 19 dargestellten Variante sind das Modem-IC 26 sowie die Telefon-Ankopplungsschaltung 25 von der im Basis-Elektrizitätszähler 3 enthaltenen Elektrizitätszähler-Hauptspeisung gespeist, die so ausgebildet ist dass eine galvanische Trennung einer vom Modem-IC 26 und von der Telefon-Ankopplungsschaltung 25 benötigten Speise-Gleichspannung DC durch einen Transformator der Hauptspeisung erfolgt. Die letztere speist die Reihenschaltung 26;25 über die beiden Leitungen 24. In der in der Fig. 20 dargestellten Variante sind das Modem-IC 26 sowie die Telefon-Ankopplungsschaltung 25 von einem im Kommunikations-Baustein enthaltenen Gleichstrom/Gleichstrom-Wandler 21 gespeist der so ausgebildet ist, dass eine galvanische Trennung der vom Modem-IC 26 und von der Telefon-Ankopplungsschaltung 25 benötigten Speise-Gleichspannung DC innerhalb des Gleichstrom/Gleichstrom-Wandlers 21 erfolgt. Der letztere ist eingangsseitig von der Elektrizitätszähler-Hauptspeisung gespeist.

In der in der Fig. 21 dargestellten Variante enthält die Schnittstellen-Anordnung 14a bzw. 14b jeweils eine Reihenschaltung in der angegebenen Reihenfolge des mit Steuerfunktionen versehenen Modem-IC's 26, der galvanischen Trennschaltung 17 und der Telefon-Ankopplungsschaltung 25. Die letztere ist wieder so ausgebildet, dass sie einer Telefon-Schnittstelle bildet. In der in der Fig. 22 dargestellten Variante ist die Schnittstellen-Anordnung 14a bzw. 14b jeweils ähnlich aufgebaut wie in der Fig. 21, mit dem Unterschied, dass das mit Steuerfunktionen versehene Modem-IC 26 parallele Bus-Verbindungen, nämlich einen parallelen Daten-Bus 37 und einen parallelen Steuerleitungs-Bus 38 besitzt zum Anschluss des Kommunikations-Mikrocomputers 10. Das Modem-IC 26 ist in diesem Fall mit parallelen Mikrocomputer-Schnittstellen versehen. In den in der Fig. 21 und Fig. 22 dargestellten Varianten der Schnittstellen-Anordnungen 14a und 14b speist die im Basis-Elektrizitätszähler 3 enthaltene Elektrizitätszähler-Hauptspeisung das Modem-IC 26 über die beiden Leitungen 24.

## Patentansprüche

1. Elektrizitätszähler mit einem einen Mikrocomputer (5) aufweisenden Basis-Elektrizitätszähler (3), der mit einem oder mehreren austauschbaren Zählerbausteinen (1, 2) bestückt ist, die wahlweise jeweils eine oder mehrere Ausführungs-Varianten besitzen, die sich in ihrer Funktionalität unterscheiden, dadurch gekennzeichnet, dass
- der Zählerbaustein (1, 2) mindestens ein, den betreffenden Zählerbaustein (1, 2) und/oder die Ausführungs-Variante kennzeichnendes Identifikations-Merkmal aufweist,
- welches vom Mikrocomputer (5) des Basis-Elektrizitätszählers (3) lesbar ist zwecks dortiger Verarbeitung und Interpretation seines Informationsinhaltes oder zwecks Überlassung des Identifikations-Merkmals an einer Applikations-Software zur Interpretation des Informationsinhaltes.

2. Elektrizitätszähler nach Anspruch 1, dadurch gekennzeichnet, dass eine Software des Mikrocomputers (5) beziehungsweise die Applikations-Software so ausgebildet ist, dass sie bei der Interpretation des Informationsinhaltes des Identifikations-Merkmals erkennt, ob zum betreffenden Zählerbaustein (1, 2) beziehungsweise zur betreffenden Ausführungs-Variante eine entsprechende Parametrierung bereits im Basis-Elektrizitätszähler (3) vorhanden ist, ansonsten durch den Basis-Elektrizitätszähler (3) eine Warnung und/oder eine Aufforderung zur Umparametrierung und/oder eine softwaremässige Betriebssperrung des betreffenden Zählerbausteins (1, 2) erfolgt.

3. Elektrizitätszähler nach Anspruch 1 oder 2, dadurch gekennzeichnet, dass das Identifikations-Merkmal in einem Speicher des betreffenden Zählerbausteins (1, 2) gespeichert ist oder ein von einem Codierer des Zählerbausteins (1, 2) erzeugtes Identifikations-Merkmal ist.

4. Elektrizitätszähler nach Anspruch 3, dadurch gekennzeichnet, dass der Codierer aus einer Reihe von "Pull up"- oder "Pull down"-Widerständen besteht und/oder das Identifikations-Merkmal mittels Codierschalter implementiert ist wobei das Identifikations-Merkmal parallel oder seriell vom Mikrocomputer (5) lesbar ist.

5. Elektrizitätszähler nach einem der Ansprüche 1 bis 4, dadurch gekennzeichnet, dass das Identifikations-Merkmal eine fortlaufende Nummer eines Zählerbausteins (1, 2) beziehungsweise einer Ausführungs-Variante ist oder, dass es ein Kennmerkmal ist, welches eine Aussage bezüglich der Funktionalität des Zählerbausteins (1, 2) beziehungsweise der Ausführungs-Variante enthält.

6. Elektrizitätszähler nach Anspruch 1, dadurch gekennzeichnet, dass das Identifikations-Merkmal eine zum betreffenden Zählerbaustein (1, 2) beziehungsweise zur betreffenden Ausführungs-Variante gehörende Parametrierung ist, die in einem Speicher des Zählerbausteins (1, 2) gespeichert ist und, vom Mikrocomputer (5) gelesen, zur Parametrierung des Basis-Elektrizitätszählers (3) dient.

7. Elektrizitätszähler nach einem der Ansprüche 1 bis 6, dadurch gekennzeichnet, dass eine anfänglich vorhandene Bestückung des Basis-Elektrizitätszählers (3) mit Zählerbausteinen (1, 2) und/oder Ausführungs-Varianten nachträglich änderbar ist und dass zur Erkennung einer Bestückungsänderung eine Software des Mikrocomputers (5) so ausgebildet ist, dass der letztere periodisch und/oder bei Inbetriebsetzungen des Elektrizitätszählers automatisch die Identifikations-Merkmale der vorhandenen Zählerbausteine (1, 2) liest und auswertet.

8. Elektrizitätszähler nach einem der Ansprüche 1 bis 7, dadurch gekennzeichnet, dass einer der Zählerbausteine (2) ein Kommunikations-Baustein ist und einen Kommunikations-Mikrocomputer (10) enthält, der jeweils über eine externe zugehörige Schnittstellen-Anordnung (14a, 14b) mit einem oder mehreren Übertragungskanälen (15a, 15b) verbunden ist.

9. Elektrizitätszähler nach Anspruch 8, dadurch gekennzeichnet, dass zwei interne UART-Schnittstellen (10a, 10b) des Kommunikations-Mikrocomputers (10) über je eine zugehörige Schnittstellen-Anordnung (14a bzw. 14b) mit je einem Übertragungskanal (15a bzw. 15b) verbunden sind.

10. Elektrizitätszähler nach Anspruch 8, dadurch gekennzeichnet, dass eine interne UART-Schnittstelle (10a) des Kommunikations-Mikrocomputers (10) über eine erste Schnittstellen-Anordnung (14a) mit einem zugehörigen ersten Übertragungskanal (15a) verbunden ist und dass der Kommunikations-Mikrocomputer (10) in der angegebenen Reihenfolge über eine externe UART-Schnittstelle (16) und eine zweite Schnittstellen-Anordnung (14b) mit einem zugehörigen zweiten Übertragungskanal (15b) verbunden ist.

11. Elektrizitätszähler nach Ansprüche 8, dadurch gekennzeichnet, dass eine interne UART-Schnittstelle (10a) des Kommunikations-Mikrocomputers (10) über einen gemeinsamen externen Signal-Multiplexer (19) mit zwei Schnittstellen-Anordnungen (14a, 14b) verbunden ist, die jeweils auf einen zugehörigen Übertragungskanal (15a bzw. 15b) geführt sind.

12. Elektrizitätszähler nach Anspruch 8, dadurch gekennzeichnet, dass der Kommunikations-Mikrocomputer (10) in der angegebenen Reihenfolge jeweils Über eine externe UART-Schnittstelle (16a bzw. 16b) und eine Schnittstellen-Anordnung (14a bzw. 14b) mit je einem zugehörigen Übertragungskanal (15a bzw. 15b) verbunden ist.

13. Elektrizitätszähler nach Anspruch 8, dadurch gekennzeichnet, dass der Kommunikations-Mikrocomputer (10) über eine Dualausführung einer externen UART-Schnittstelle (16c) mit zwei Schnittstellen-Anordnungen (14a, 14b) verbunden ist, die jeweils auf einen zugehörigen Übertragungskanal (15a bzw. 15b) geführt sind.

14. Elektrizitätszähler nach einem der Ansprüche 8 bis 13, dadurch gekennzeichnet, dass die Schnittstellen-Anordnung (14a, 14b) jeweils eine Reihenschaltung einer galvanischen Trennschaltung (17) und einer Pegelanpass-Schaltung (18) enthält.

15. Elektrizitätszähler nach Anspruch 14, dadurch gekennzeichnet, dass die Pegelanpass-Schaltung (18) so ausgebildet ist, dass sie eine normierte RS232-Schnittstelle, RS485-Schnittstelle oder M-Bus-Schnittstelle bildet, und dass die Pegelanpass-Schaltung (18) von einer im Basis-Elektrizitätszähler (3) enthaltenen Elektrizitätszähler-Hauptspeisung gespeist ist, die so ausgebildet ist, dass eine galvanische Trennung einer von der Pegelanpass-Schaltung (18) benötigten Speise-Gleichspannung (DC) durch einen Transformator der Hauptspeisung erfolgt.

16. Elektrizitätszähler nach Anspruch 14, dadurch gekennzeichnet, dass die Pegelanpass-Schaltung (18) so ausgebildet ist, dass sie eine normierte RS232-Schnittstelle, RS485-Schnittstelle oder M-Bus-Schnittstelle bildet, und dass die Pegelanpass-Schaltung (18) von einem im Kommunikations-Baustein enthaltenen Gleichstrom/Gleichstrom-Wandler (21) gespeist ist, der so ausgebildet ist, dass eine galvanische Trennung einer von der Pegelanpass-Schaltung (18) benötigten Speise-Gleichspannung (DC) innerhalb des Gleichstrom/Gleichstrom-Wandlers (21) erfolgt.

17. Elektrizitätszähler nach Anspruch 14, dadurch gekennzeichnet, dass die Pegelanpass-Schaltung (18) so ausgebildet ist, dass sie eine normierte RS232-Schnittstelle, RS485-Schnittstelle oder M-Bus-Schnittstelle bildet, und dass die Pegelanpass-Schaltung (18) von einem im Kommunikations-Baustein enthaltenen Netzgerät (22) gespeist ist, welches so ausgebildet ist, dass eine galvanische Trennung einer von der Pegelanpass-Schaltung (18) benötigten Speise-Gleichspannung (DC) innerhalb des Netzgerätes (22) erfolgt.

18. Elektrizitätszähler nach Anspruch 14, dadurch gekennzeichnet, dass die Pegelanpass-Schaltung (18) so ausgebildet ist, dass sie eine normierte M-Bus-Schnittstelle bildet, und dass übertragungskanalseitige Anschlüsse der Pegelanpass-Schaltung (18) mit Speisespannungs-Anschlüssen der Pegelanpass-Schaltung (18) verbunden sind.

19. Elektrizitätszähler nach einem der Ansprüche 8 bis 13, dadurch gekennzeichnet, dass die Schnittstellen-Anordnung (14a, 14b) jeweils eine Reihenschaltung in der angegebenen Reihenfolge eines ersten ASK-Modems (23a), einer galvanischen Trennschaltungen (17) und eines zweiten ASK-Modems (23b) enthält und dass das zweite ASK-Modem (23b) so ausgebildet ist, dass es eine RS232-Schnittstelle bildet.

20. Elektrizitätszähler nach einem der Ansprüche 8 bis 13, dadurch gekennzeichnet, dass die Schnittstellen-Anordnung (14a, 14b) jeweils eine Reihenschaltung in der angegebenen Reihenfolge einer galvanischen Trennschaltung (17), eines mit Steuerfunktionen versehenen Modem-IC's (26) und einer Telefon-Ankopplungsschaltung (25) enthält, dass die Telefon-Ankopplungsschaltung (25) so ausgebildet ist, dass sie eine Telefon-Schnittstelle bildet und dass das Modem-IC (26) sowie die Telefon-Ankopplungsschaltung (25) von einer im Basis-Elektrizitätszähler (3) enthaltenen Elektrizitätszähler-Hauptspeisung gespeist sind, die so ausgebildet ist, dass eine galvanische Trennung einer vom Modem-IC (26) und von der Telefon-Ankopplungsschaltung (25) benötigten Speise-Gleichspannung (DC) durch einen Transformator der Hauptspeisung erfolgt.

21. Elektrizitätszähler nach einem der Ansprüche 8 bis 13, dadurch gekennzeichnet, dass die Schnittstellen-Anordnung (14a, 14b) jeweils eine Reihenschaltung in der angegebenen Reihenfolge einer galvanischen Trennschaltung (17), eines mit Steuerfunktionen versehenen Modem-IC's (26) und einer Telefon-Ankopplungsschaltung (25) enthält, dass die Telefon-Ankopplungsschaltung (25) so ausgebildet ist, dass sie einer Telefon-Schnittstelle bildet und dass das Modem-IC (26) sowie die Telefon-Ankopplungsschaltung (25) von einem im Kommunikations-Baustein enthaltenen Gleichstrom/Gleichstrom-Wandler (21) gespeist sind, der so ausgebildet ist, dass eine galvanische Trennung einer vom Modem-IC (26) und von der Telefon-Ankopplungsschaltung (25) benötigten Speise-Gleichspannung (DC) innerhalb des Gleichstrom/Gleichstrom-Wandlers (21) erfolgt.

22. Elektrizitätszähler nach einem der Ansprüche 8 bis 13, dadurch gekennzeichnet, dass die Schnittstellen-Anordnung (14a, 14b) jeweils eine Reihenschaltung in der angegebenen Reihenfolge eines mit Steuerfunktionen versehenen Modem-IC's (26), einer galvanischen Trennschaltung (17) und einer Telefon-Ankopplungsschaltung (25) enthält und dass die Telefon-Ankopplungsschaltung (25) so ausgebildet ist, dass sie einer Telefon-Schnittstelle bildet.

23. Elektrizitätszähler nach Anspruch 22, dadurch gekennzeichnet, dass das mit Steuerfunktionen versehene Modem-IC (26) parallele Bus-Verbindungen (37, 38) besitzt zum Anschluss des Kommunikations-Mikrocomputers (10).
